# EUROPEAN PATENT APPLICATION

(11) **EP 4 546 985 A1**
(43) Date of publication of application: **30.04.2025**
(21) Application number: 24200509.8
(22) Date of filing: 16.09.2024
(51) Int. Cl.: H10H 29/02, H10H 29/03

(54) **METHOD FOR MANUFACTURING DISPLAY DEVICE**

(30) Priority: 26.10.2023 KR 20230144880
(71) Applicant: Samsung Display Co., Ltd., Gyeonggi-do 17113 (KR)
(72) Inventor: SIM, Jun Bo, 17113 Giheung-gu, Yongin-si, Gyeonggi-do (KR); KIM, Jun Youn, 17113 Giheung-gu, Yongin-si, Gyeonggi-do (KR); CHO, Joo Woan, 17113 Giheung-gu, Yongin-si, Gyeonggi-do (KR); PARK, Jin Taek, 17113 Giheung-gu, Yongin-si, Gyeonggi-do (KR); YEO, So Young, 17113 Giheung-gu, Yongin-si, Gyeonggi-do (KR); LEE, Dong Eon, 17113 Giheung-gu, Yongin-si, Gyeonggi-do (KR); JUNG, Jae Hoon, 17113 Giheung-gu, Yongin-si, Gyeonggi-do (KR)
(74) Representative: Dr. Weitzel & Partner

(57) **Abstract**

A method for manufacturing a display device includes manufacturing an epitaxial wafer including an epitaxial thin film, dividing the epitaxial wafer into wafer dies having a size corresponding to an area of each cell area of a backplane substrate including cell areas, transferring the wafer dies to a carrier substrate, forming a conductive bonding layer on epitaxial dies of the wafer dies, disposing the carrier substrate on the backplane substrate such that the epitaxial dies are disposed in each cell area of the backplane substrate and bonding the epitaxial dies onto the backplane substrate, removing the carrier substrate from the epitaxial dies, and etching the epitaxial dies to form respective light emitting elements in emission areas included in each cell area of the backplane substrate.

## Description

### BACKGROUND

### 1. Technical Field

The invention relates to a method for manufacturing a display device.

### 2. Description of the Related Art

The importance of display devices has gradually increased with the development of multimedia. Accordingly, various display devices such as liquid crystal display devices and light emitting display devices have been developed. Among them, the light emitting display devices include a display panel including light emitting elements, and have been applied to various types of electronic devices including virtual reality (VR) devices, augmented reality (AR) devices, or the like, as well as portable electronic devices or televisions.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

Aspects of the invention provide a method for manufacturing a display device capable of increasing manufacturing efficiency of a display panel including light emitting elements.

However, aspects of the invention are not restricted to the ones set forth herein. The above and other aspects of the invention will become more apparent to one of ordinary skill in the art to which the invention pertains by referencing the detailed description of the invention given below.

The invention is defined by the independent claims. According to a first aspect of the invention, there is provided a method for manufacturing a display device that includes manufacturing an epitaxial wafer including an epitaxial thin film; dividing the epitaxial wafer into wafer dies having a size corresponding to an area of each cell area of a backplane substrate including cell areas; transferring the wafer dies to a carrier substrate; forming a conductive bonding layer on epitaxial dies of the wafer dies; disposing the carrier substrate on the backplane substrate such that the epitaxial dies are disposed in each cell area of the backplane substrate and bonding the epitaxial dies onto the backplane substrate; removing the carrier substrate from the epitaxial dies; and etching the epitaxial dies to form respective light emitting elements in emission areas included in each cell area of the backplane substrate.

In an embodiment, the carrier substrate may have a size corresponding to an area of the backplane substrate and include cell areas corresponding to the cell areas of the backplane substrate.

In an embodiment, the transferring of the wafer dies to the carrier substrate may include aligning the wafer dies with the respective cell areas of the carrier substrate.

In an embodiment, the wafer dies may include respective wafer substrates and respective epitaxial dies divided from the epitaxial wafer.

In an embodiment, the method for manufacturing a display device may further include filling gaps between the wafer dies by applying a filler onto the carrier substrate on which the wafer dies are disposed and planarizing an upper surface of the carrier substrate on which the wafer dies and the filler are disposed after the transferring of the wafer dies onto the carrier substrate and before the forming of the conductive bonding layer.

In an embodiment, in the planarizing of the upper surface of the carrier substrate, the epitaxial dies may be exposed by removing the respective wafer substrates from the wafer dies, and the conductive bonding layer may be formed by applying a conductive bonding material onto the upper surface of the carrier substrate on which the epitaxial dies are exposed.

In an embodiment, the method for manufacturing a display device may further include selecting products by evaluating the wafer dies, and the wafer dies selected as the products may be transferred to the carrier substrate before the transferring of the wafer dies to the carrier substrate.

In an embodiment, the backplane substrate may include pixel electrodes individually disposed in the emission areas of each cell area of the backplane substrate.

In an embodiment, in the etching of the epitaxial dies, the respective light emitting elements may be formed on the pixel electrodes.

In an embodiment, the backplane substrate may further include first bonding electrodes disposed on the pixel electrodes.

In an embodiment, in the bonding of the epitaxial dies onto the backplane substrate, the epitaxial dies may be bonded onto the first bonding electrodes by a transient liquid phase (TLP) bonding method or a thermal compression (TC) bonding method.

In an embodiment, the method for manufacturing a display device may further include forming second bonding electrodes between the first bonding electrodes and the light emitting elements by etching the conductive bonding layer.

In an embodiment, in the removing of the carrier substrate, the carrier substrate may be removed from the epitaxial dies by a laser lift off (LLO) method.

In an embodiment, the method for manufacturing a display device may further include forming a common electrode on the light emitting elements in each cell area of the backplane substrate.

In an embodiment, the method for manufacturing a display device may further include forming lens-type optical structures on a light emitting element layer including the light emitting elements and the common electrode.

In an embodiment, the method for manufacturing a display device may further include separating respective cells corresponding to the cell areas into individual display panels by cutting the backplane substrate based on the cell areas of the backplane substrate.

According to a second aspect of the invention, there is provided a method for manufacturing a display device, that includes preparing a backplane substrate including cell areas and pixel electrodes individually disposed in emission areas disposed in each of the cell areas; manufacturing wafer dies having a size corresponding to each of the cell areas and including respective epitaxial dies; preparing a carrier substrate having a size corresponding to the backplane substrate and including cell areas corresponding to the cell areas of the backplane substrate; transferring the wafer dies to the carrier substrate; planarizing an upper surface of the carrier substrate such that the epitaxial dies of the wafer dies are exposed and forming a conductive bonding layer on the epitaxial dies; bonding the epitaxial dies onto the pixel electrodes using the conductive bonding layer; and forming respective light emitting elements on the pixel electrodes by etching the epitaxial dies.

In an embodiment, the transferring of the wafer dies to the carrier substrate may include aligning the wafer dies with the respective cell areas of the carrier substrate.

In an embodiment, the backplane substrate may further include first bonding electrodes disposed on the pixel electrodes, and the epitaxial dies may be bonded onto the first bonding electrodes by a TLP bonding method or a TC bonding method.

In an embodiment, the method for manufacturing a display device may further include forming second bonding electrodes between the first bonding electrodes and the light emitting elements by etching the conductive bonding layer.

According to embodiments, an epitaxial wafer may be divided in a size corresponding to each cell area of a backplane substrate and transferred to a carrier substrate, and epitaxial dies may be bonded onto each cell area of the backplane substrate and etched to form light emitting elements of pixels.

With a method for manufacturing a display device according to embodiments, use efficiency of a wafer substrate used for growth of an epitaxial thin film may be increased and a manufacturing cost of a display panel may be reduced. A manufacturing process of the display panel may be facilitated and/or simplified, and an alignment error related to positions where the light emitting elements are formed may be prevented or reduced. Accordingly, manufacturing efficiency of the display panel including the light emitting elements and the display device including the display panel may be increased and yields of the display panel and the display device may be improved.

However, effects according to the invention are not limited to those described above and various other effects are incorporated herein.

### BRIEF DESCRIPTION OF THE DRAWINGS

The above and other aspects and features of the invention will become more apparent by describing in detail embodiments thereof with reference to the attached drawings, in which:
FIG. 1 is a schematic perspective view illustrating a display device according to an embodiment;
FIG. 2 is a schematic plan view illustrating an example of area A of FIG. 1;
FIG. 3 is a schematic cross-sectional view illustrating an example of a cross section of a display panel taken along line X1-X1' in FIG. 2;
FIG. 4 is a schematic cross-sectional view illustrating a light emitting element according to an embodiment;
FIG. 5 is a schematic cross-sectional view illustrating a light emitting element according to an embodiment;
FIG. 6 is a schematic cross-sectional view illustrating a light emitting element according to an embodiment;
FIG. 7 is a flowchart illustrating a method for manufacturing the display device according to an embodiment;
FIGS. 8 to 22 are views for describing the method for manufacturing the display panel according to an embodiment;
FIG. 23 is an illustrative view illustrating a virtual reality device including a display device according to an embodiment;
FIG. 24 is an illustrative view illustrating a smart device including a display device according to an embodiment;
FIG. 25 is an illustrative view illustrating an instrument board and a center fascia of a vehicle including display devices according to an embodiment; and
FIG. 26 is an illustrative view illustrating a transparent display device including a display device according to an embodiment.

### DETAILED DESCRIPTION OF THE EMBODIMENTS

The invention will now be described more fully hereinafter with reference to the accompanying drawings, in which embodiments are shown. This invention may, however, be embodied in different forms and should not be construed as limited to the embodiments set forth herein. Rather, these embodiments are provided so that this invention will be thorough and complete, and will fully convey the scope of the invention to those skilled in the art.

In the drawings, sizes, thicknesses, ratios, and dimensions of the elements may be exaggerated for ease of description and for clarity. Like numbers refer to like elements throughout.

As used herein, the singular forms, "a," "an," and "the" are intended to include the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the invention.

It will also be understood that when an element or a layer is referred to as being "on" another element or layer, it can be directly on the other element or layer, or intervening layers may also be present. The same reference numbers indicate the same components throughout the specification.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

When an element is described as `not overlapping' or 'to not overlap' another element, this may include that the elements are spaced apart from each other, offset from each other, or set aside from each other or any other suitable term as would be appreciated and understood by those of ordinary skill in the art.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

It will be understood that the terms "connected to" or "coupled to" may include a physical or electrical connection or coupling.

Features of each of various embodiments may be partially or entirely combined with each other and may technically variously interwork with each other, and respective embodiments may be implemented independently of each other or may be implemented together in association with each other.

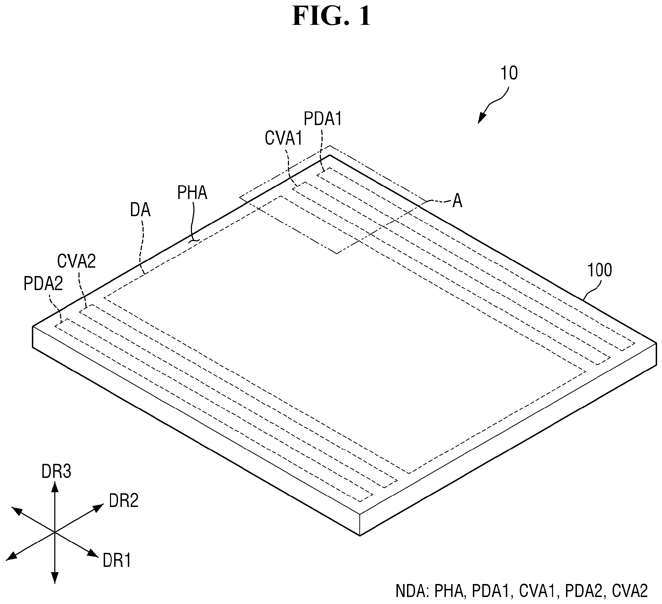

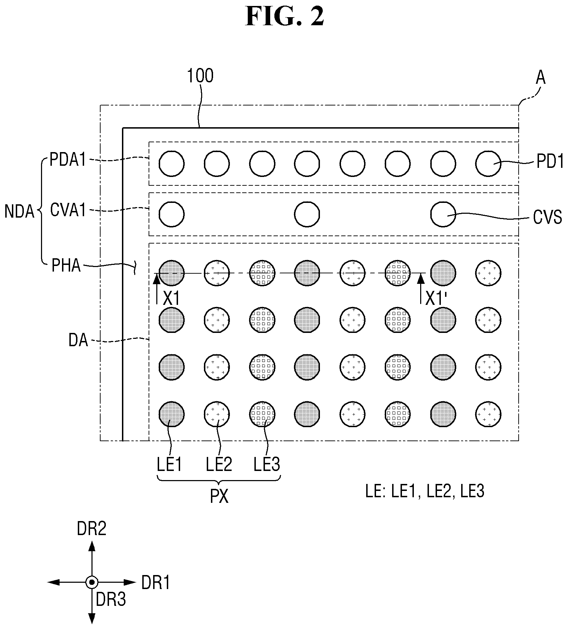

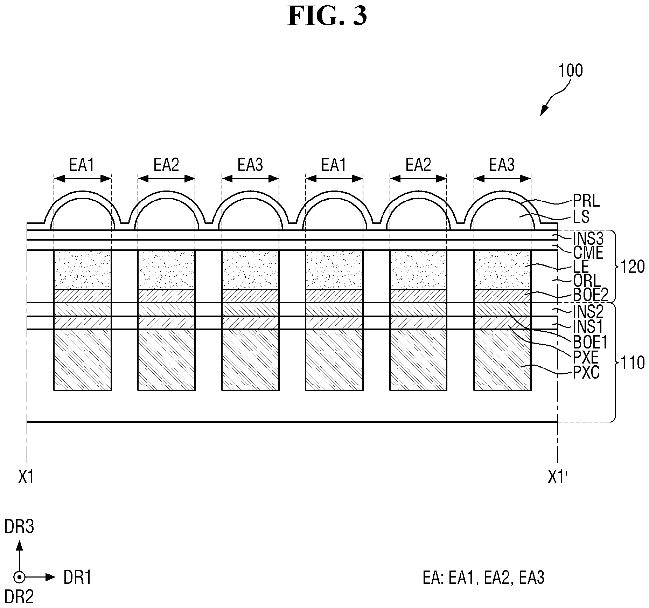

FIG. 1 is a schematic perspective view illustrating a display device 10 which may be manufactured according to an embodiment of the inventive method. FIG. 2 is a schematic plan view illustrating an example of area A of FIG. 1. FIG. 3 is a schematic cross-sectional view illustrating an example of a cross section of a display panel 100 taken along line X1-X1' in FIG. 2.

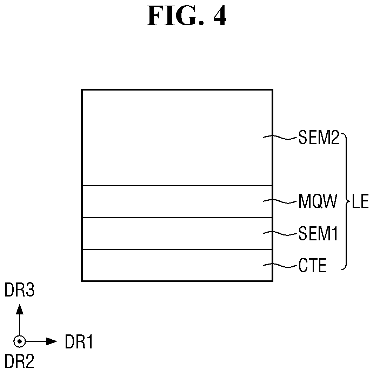

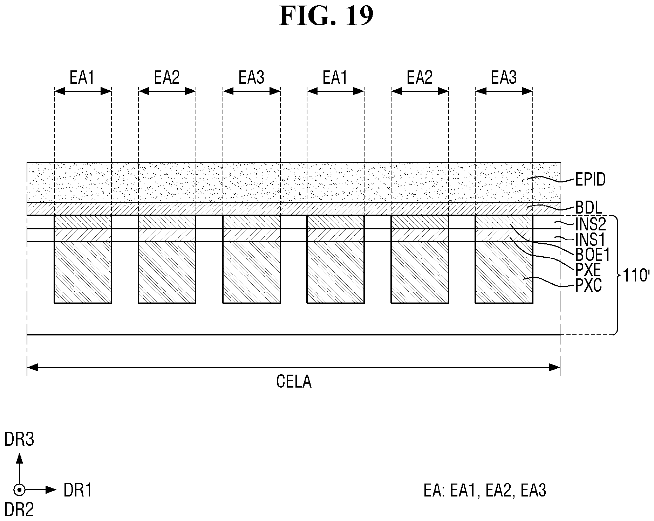

FIGS. 1 to 3 illustrate an embodiment in which the display device 10 is a light emitting diode on silicon (LEDoS) in which light emitting diodes are disposed as light emitting elements LE on a semiconductor circuit board formed by a semiconductor process using a silicon wafer (for example, a backplane substrate 110 of a display panel 100 on which pixel circuits PXC and the like are formed based on a silicon wafer). However, a device including the light emitting elements LE according to embodiments is not limited thereto. For example, the light emitting elements LE manufactured with embodiments of the inventive method may be applied to display devices of other types and/or structures or be applied to devices of other types and/or structures such as illumination devices. As an example, embodiments described with reference to FIGS. 4 to 19 may also be applied to manufacturing of devices of other types and/or structures including the light emitting elements LE.

In FIGS. 1 to 3, a first direction DR1 may refer to a transverse direction of the display panel 100, and a second direction DR2 may refer to a longitudinal direction of the display panel 100. A third direction DR3 may refer to a thickness direction of the display panel 100.

First, referring to FIGS. 1 and 2, the display device 10 according to an embodiment may include the display panel 100 including a display area DA and a non-display area NDA.

The display panel 100 may have a rectangular shape, in plan view, having long sides in the first direction DR1 and short sides in the second direction DR2. However, the shape of the display panel 100 in plan view is not limited thereto, and the display panel 100 may also have other shapes. For example, the display panel 100 may have other polygonal shapes other than the rectangular shape, a circular shape, an elliptical shape, or an irregular shape in plan view.

The display area DA may be an area in which an image is displayed, and the non-display area NDA may be an area in which the image is not displayed. In an embodiment, a shape of the display area DA in plan view may follow the shape of the display panel 100 in plan view. It has been illustrated in FIG. 1 that the shape of the display area DA in plan view is a rectangular shape. The display area DA may be disposed in a central area of the display panel 100. The non-display area NDA may be disposed around the display area DA. As an example, the non-display areas NDA may surround the display area DA.

The display area DA may include pixels PX. Each pixel PX may include at least two light emitting elements LE.

In an embodiment, each pixel PX may include three light emitting elements LE. For example, each pixel PX may include a first light emitting element LE1, a second light emitting element LE2, and a third light emitting element LE3. The number and/or type of light emitting elements LE provided to each of the pixels PX may be variously changed according to embodiments.

In an embodiment, each pixel PX may include light emitting elements LE that emit light of different colors. As an example, the first light emitting element LE1, the second light emitting element LE2, and the third light emitting element LE3 may emit light of different colors.

The first light emitting element LE1 may emit first light. The first light may be red light. For example, a main peak wavelength (R-peak) of the first light may be positioned in a range of about 600 nm to about 750 nm, but embodiments are not limited thereto.

The second light emitting element LE2 may emit second light. The second light may be green light. For example, a main peak wavelength (G-peak) of the second light may be in a range of about 480 nm to about 560 nm, but embodiments are not limited thereto.

The third light emitting element LE3 may emit third light. The third light may be blue light. For example, a main peak wavelength (B-peak) of the third light may be in a range of about 370 nm to about 460 nm, but embodiments are not limited thereto.

In an embodiment, the first light emitting element LE1, the second light emitting element LE2, and the third light emitting element LE3 may emit light of the same color. On at least one light emitting element LE of the first light emitting element LE1, the second light emitting element LE2, and the third light emitting element LE3, a light conversion layer including a light conversion element (for example, a quantum dot) for converting a color of light emitted from the at least one light emitting element LE (or a wavelength band corresponding to the color) into light of another color (or a wavelength band corresponding to another color) may be disposed.

In an embodiment, the first light emitting element LE1, the second light emitting element LE2, and the third light emitting element LE3 of each pixel PX may be sequentially disposed in the first direction DR1. In other words, a plurality of light emitting elements LE1 may be sequentially disposed in the first direction DR1. Further, a plurality of second light emitting elements LE2 may be sequentially disposed in the first direction DR1. Further, a plurality of third light emitting elements LE3 may be sequentially disposed in the first direction DR1. In an embodiment, the first light emitting elements LE1 may be arranged (or disposed) in the second direction DR2. The second light emitting elements LE2 may be arranged in the second direction DR2. The third light emitting elements LE3 may be arranged in the second direction DR2. This may mean arranged as described with reference to the first direction DR1. For example, in each pixel column extending along the second direction DR2, the first light emitting elements LE1, the second light emitting elements LE2, or the third light emitting elements LE3 may be arranged. Arrangement structures of the pixels PX and the light emitting elements LE provided in the pixels PX may be variously changed according to embodiments.

In an embodiment, the light emitting elements LE may be arranged in the display area DA at substantially equal intervals, but embodiments are not limited thereto. For example, positions and/or arrangement intervals of the light emitting elements LE may be variously changed according to embodiments.

In an embodiment, sizes (for example, areas) of the light emitting elements LE may be substantially the same as each other. For example, the first light emitting element LE1, the second light emitting element LE2, and the third light emitting element LE3 may have substantially the same size and/or geometry. However, embodiments are not limited thereto, and a size of each of the light emitting element LE, areas of emission areas corresponding to the light emitting elements LE, and the like, may be variously changed according to embodiments.

In an embodiment, the light emitting elements LE may have a circular shape in plan view, but embodiments are not limited thereto. For example, the light emitting elements LE may have a rectangular shape or other polygonal shapes, an elliptical shape, or an irregular shape. The light emitting elements LE may have substantially the same shape in plan view or may have different shapes for each group in plan view.

The non-display area NDA may include a first common voltage supply area CVA1, a second common voltage supply area CVA2, a first pad area PDA1, a second pad area PDA2, and a peripheral area PHA.

The first common voltage supply area CVA1 may be disposed between the first pad area PDA1 and the display area DA. The second common voltage supply area CVA2 may be disposed between the second pad area PDA2 and the display area DA. Each of the first common voltage supply area CVA1 and the second common voltage supply area CVA2 may include common electrode connection parts CVS connected to a common electrode (for example, a common electrode CME of FIG. 3). For example, the common electrode may extend from the display area DA to the first common voltage supply area CVA1 and the second common voltage supply area CVA2 and may be electrically connected to the common electrode connection parts CVS. A common voltage may be supplied to the common electrode through common electrode connection parts CVS.

The common electrode connection parts CVS may be disposed in a common voltage supply area (for example, the first common voltage supply area CVA1 and/or the second common voltage supply area CVA2) of the non-display area NDA. The common electrode connection parts CVS may each include a conductive material (for example, a metal material such as aluminum (Al)). FIGS. 1 and 2 illustrate the display device 10 in which the common electrode connection parts CVS are positioned in the non-display area NDA, but embodiments are not limited thereto. For example, the common electrode connection parts CVS may also be positioned in the display area DA. As an example, the common electrode connection parts CVS may be positioned in pixel areas or positioned between the pixel areas.

The common electrode connection parts CVS of the first common voltage supply area CVA1 may be electrically connected to any one of first pads PD1 of the first pad area PDA1. For example, the common electrode connection parts CVS of the first common voltage supply area CVA1 may receive a common voltage from any one of the first pads PD1 of the first pad area PDA1.

The first pads PD1 may be disposed in the first pad area PDA1. The first pads PD1 may be connected to a circuit board (not illustrated) through conductive connection members. For example, the first pads PD1 may be electrically connected to circuit pads provided on the circuit board through wires.

The common electrode connection parts CVS of the second common voltage supply area CVA2 may be electrically connected to any one of second pads of the second pad area PDA2. For example, the common electrode connection parts CVS of the second common voltage supply area CVA2 may receive a common voltage from any one of the second pads of the second pad area PDA2. In an embodiment, the display panel 100 may not include the second common voltage supply area CVA2.

The first pad area PDA1 may be disposed on one side (for example, the upper side) of the display panel 100. The first pad area PDA1 may include the first pads PD1 connected to an external circuit board.

The second pad area PDA2 may be disposed on the other side (for example, the lower side) of the display panel 100. The second pad area PDA2 may include the second pads connected to an external circuit board. In an embodiment, the display panel 100 may not include the second pad area PDA2.

The second pads may be disposed in the second pad area PDA2 of the non-display area NDA. The second pads may be connected to a circuit board (not illustrated) through conductive connection members. For example, the second pads may be electrically connected to circuit pads provided on the circuit board through wires.

The peripheral area PHA may be the remaining area of the non-display area NDA excluding the first common voltage supply area CVA1, the second common voltage supply area CVA2, the first pad area PDA1, and the second pad area PDA2. The peripheral area PHA may surround the first common voltage supply area CVA1, the second common voltage supply area CVA2, the first pad area PDA1, and the second pad area PDA2 as well as the display area DA.

Referring to FIG. 3 and FIGS. 1 and 2, the display panel 100 may include a backplane substrate 110 and a light emitting element layer 120. In an embodiment, the display panel 100 may further include optical structures (or light emission structures), for example, lens-type optical structures LS, provided on the light emitting element layer 120.

The display panel 100 may further include additional components according to embodiments. As an example, the display panel 100 may further include a light conversion layer for converting a color and/or a wavelength of light emitted from at least some light emitting elements LE, a color filter layer for controlling each emission area EA to emit light of a selectable color, and the like within the scope of the invention.

The display panel 100 may include emission areas EA positioned in the display area DA. Each of the emission areas EA may include at least one light emitting element LE. For example, the emission areas EA may include first emission areas EA1 in which at least one first light emitting element LE1 is provided, second emission areas EA2 in which at least one second light emitting element LE2 is provided, and third emission areas EA3 in which at least one third light emitting element LE3 is provided. In an embodiment, the first light, the second light, and the third light may be emitted from the first emission area EA1, the second emission area EA2, and the third emission area EA3, respectively.

The first emission areas EA1, second emission areas EA2 and third emission area EA3 may be spaced from each other. A lens-type optical structures LS may be disposed at each emission areas EA1, EA2, EA3.

The backplane substrate 110 may include the display area DA including the emission areas EA. In an embodiment, the backplane substrate 110 may be a semiconductor circuit board formed by a semiconductor process using a silicon wafer. For example, the silicon wafer may be used as a base member for forming the display panel 100.

The backplane substrate 110 may include pixel circuits PXC and pixel electrodes PXE provided in the display area DA. For example, at least one light emitting element LE may be provided in each emission area EA of the display panel 100, and the backplane substrate 110 may include pixel circuits PXC and pixel electrodes PXE connected (for example, electrically connected) to the respective light emitting elements LE disposed in the respective emission areas EA.

In an embodiment, the backplane substrate 110 may further include first bonding electrodes BOE1 (also referred to as "first contact electrodes" or "first connection electrodes") disposed on the respective pixel electrodes PXE. In an embodiment, the backplane substrate 110 may further include a first insulating layer INS1 disposed around the pixel electrodes PXE and/or a second insulating layer INS2 disposed around the first bonding electrodes BOE1.

The pixel circuits PXC may be provided in the display area DA so as to correspond to areas in which the respective pixels PX and/or the emission areas EA are formed. In an embodiment, each of the pixel circuits PXC may include a complementary metal oxide semiconductor (CMOS) circuit formed using a semiconductor process.

Each of the pixel circuits PXC may include at least one transistor formed through a semiconductor process. Each of the pixel circuits PXC may further include at least one capacitor formed through a semiconductor process.

The pixel circuits PXC may be electrically connected to the respective pixel electrodes PXE. For example, the pixel circuits PXC and the pixel electrodes PXE may be connected to each other so as to correspond to each other in a one-to-one manner. Each of the pixel circuits PXC may apply a pixel voltage to the pixel electrode PXE connected thereto.

The pixel electrodes PXE may be connected to the respective pixel circuits PXC. The pixel electrodes PXE may be individually provided in the respective emission areas EA and be electrically connected to the light emitting elements LE positioned in the respective emission areas EA. Accordingly, it is possible to individually and/or independently control the light emitting elements LE disposed in the respective emission areas EA.

Each of the pixel electrodes PXE may be disposed on the pixel circuit PXC corresponding thereto. In an embodiment, each of the pixel electrodes PXE may be an electrode integral with the pixel circuit PXC and exposed from the pixel circuit PXC. For example, each of the pixel electrodes PXE may protrude from an upper surface of the pixel circuit PXC. Each of the pixel electrodes PXE may receive the pixel voltage supplied from the pixel circuit PXC. The pixel electrodes PXE may each include a conductive material (for example, a metal material such as aluminum (Al)).

In an embodiment, the first insulating layer INS1 may be disposed around the pixel electrodes PXE. The first insulating layer INS1 may be provided on an upper surface of the semiconductor circuit board on which the pixel circuits PXC are formed In an embodiment, the first insulating layer INS 1 may be disposed between the pixel electrodes PXE in a form in which it surrounds the pixel electrodes PXE.

The first insulating layer INS 1 may expose at least a portion of each of the pixel electrodes PXE. For example, the first insulating layer INS1 may include openings corresponding to the pixel electrodes PXE and expose upper surfaces of the pixel electrodes PXE. The first insulating layer INS 1 may include an inorganic insulating material such as silicon oxide (SiOₓ), silicon nitride (SiNₓ), silicon oxynitride (SiOₓN_{y}), aluminum oxide (AlₓO_{y}), or aluminum nitride (AlN), or other insulating materials.

The first bonding electrodes BOE1 may be individually provided in the respective emission areas EA so as to be positioned on the respective pixel electrodes PXE. The first bonding electrodes BOE1 may be electrically connected to the respective pixel electrodes PXE. The first bonding electrodes BOE1 may be electrically connected to the light emitting elements LE positioned in the respective emission areas EA. The light emitting elements LE may be connected to the respective pixel circuits PXC through the first bonding electrodes BOE1.

The first bonding electrodes BOE1 may each include a conductive bonding material suitable for bonding or adhering the light emitting elements LE onto the pixel electrodes PXE. As an example, each of the first bonding electrodes BOE1 may be a single-layer or multilayer electrode including gold (Au), copper (Cu), aluminum (Al), tin (Sn), or other metal materials (for example, bonding metals). In an embodiment, in case that the backplane substrate 110 does not include the first bonding electrodes BOE1 and the light emitting elements LE are directly bonded or adhered onto the pixel electrodes PXE, the pixel electrodes PXE may each include a conductive material (for example, a metal material suitable for being used as a bonding metal) that may be appropriately connected to the light emitting elements LE through a bonding process, an adhering process, or the like within the scope of the invention.

In an embodiment, the second insulating layer INS2 may be disposed around the first bonding electrodes BOE1. The second insulating layer INS2 may be provided on the upper surface of the semiconductor circuit board on which the pixel circuits PXC, the pixel electrodes PXE, and/or the first insulating layer INS1 are formed. In an embodiment, the second insulating layer INS2 may be disposed between the first bonding electrodes BOE1 in a form in which it surrounds the first bonding electrodes BOE1.

The second insulating layer INS2 may expose at least a portion of each of the first bonding electrodes BOE1. For example, the second insulating layer INS2 may include openings corresponding to the first bonding electrodes BOE1 and expose upper surfaces of the first bonding electrodes BOE1. The second insulating layer INS2 may include an inorganic insulating material such as silicon oxide (SiOₓ), silicon nitride (SiNₓ), silicon oxynitride (SiOₓN_{y}), aluminum oxide (AlₓO_{y}), or aluminum nitride (AlN), or other insulating materials.

The backplane substrate 110 may further include the non-display area NDA illustrated in FIGS. 1 and 2. In an embodiment, the backplane substrate 110 may further include the common electrode connection parts CVS, the first pads PD1, the second pads, and the like, positioned in the non-display area NDA.

The light emitting element layer 120 may include second bonding electrodes BOE2, the light emitting elements LE, and a common electrode CME. In an embodiment, the light emitting element layer 120 may further include an organic film ORL disposed around the light emitting elements LE and/or a third insulating layer INS3 disposed on the common electrode CME.

In an embodiment, the light emitting element layer 120 may further include additional components. For example, the light emitting element layer 120 may further include a reflective layer, a light blocking layer, and the like, provided between the light emitting elements LE and/or on side surfaces of the light emitting elements LE.

The second bonding electrodes BOE2 may be provided at positions corresponding to the respective pixel electrodes PXE and be electrically connected to the respective pixel electrodes PXE. For example, the second bonding electrodes BOE2 may be disposed on the first bonding electrodes BOE1 provided on the respective pixel electrodes PXE. The second bonding electrodes BOE2 may be individually patterned in a form corresponding to the respective pixel electrodes PXE and/or the first bonding electrodes BOE1. For example, the second bonding electrodes BOE2 may be patterned to have a size and/or shape corresponding to the respective pixel electrodes PXE and/or the first bonding electrodes BOE1 and be separated from each other, and may be disposed on the respective first bonding electrodes BOE1.

The second bonding electrodes BOE2 may each include a conductive bonding material suitable for bonding or adhering the light emitting elements LE onto the first bonding electrodes BOE1 (or the pixel electrodes PXE). As an example, each of the second bonding electrodes BOE2 may be a single-layer or multilayer electrode including gold (Au), copper (Cu), aluminum (Al), tin (Sn), or other metal materials (for example, bonding metals).

The light emitting elements LE may be disposed on the respective second bonding electrodes BOE2. The light emitting elements LE may be electrically connected between the respective pixel electrodes PXE and the common electrode CME.

The light emitting elements LE may include semiconductor layers grown on a semiconductor substrate (for example, a wafer substrate) by epitaxial growth. For example, the light emitting elements LE may include a first semiconductor layer doped with a first conductivity-type, a second semiconductor layer doped with a second conductivity-type, and an active layer disposed between the first semiconductor layer and the second semiconductor layer.

The light emitting elements LE may be formed from epitaxial thin films of wafer dies divided from an epitaxial wafer, and may be patterned in a cell area corresponding to each display panel 100 and formed in the respective emission areas EA. A detailed description of a structure and a manufacturing method of the light emitting elements LE according to embodiments will be provided later.

The organic film ORL may be provided around the light emitting elements LE. As an example, the organic film ORL may be disposed between the emission areas EA so as to surround the emission areas EA in which the light emitting elements LE are provided, and may surround the light emitting elements LE and the second bonding electrodes BOE2. In an embodiment, the organic film ORL may be a filler filling a gap between the light emitting elements LE. The organic film ORL may expose portions, for example, upper surfaces, of the light emitting elements LE.

The organic film ORL may include an insulating material. For example, the organic film ORL may be a single-layer or multilayer organic insulating film including an acrylic resin, an epoxy resin, a phenolic resin, a polyamide resin, a polyimide resin, or other organic insulating materials.

The common electrode CME may be disposed on upper portions of the light emitting elements LE that are not covered by the organic film ORL. In an embodiment, the common electrode CME may be entirely disposed in the display area DA so as to cover the light emitting elements LE, the organic film ORL, and the like within the scope of the invention. The common electrode CME may be a common layer commonly formed in and/or connected to the light emitting elements LE of the display area DA and the pixels PX including the light emitting elements LE.

The common electrode CME may be electrically connected to the common electrode connection parts CVS disposed in the first common voltage supply area CVA1 and/or the second common voltage supply area CVA2 of FIGS. 1 and 2. Accordingly, the common electrode CME may receive the common voltage supplied through the common electrode connection parts CVS.

The common electrode CME may include a transparent conductive material capable of transmitting light therethrough. For example, the common electrode CME may be made of indium tin oxide (ITO), indium zinc oxide (IZO), or other transparent conductive materials. In an embodiment, the common electrode CME may function as a cathode electrode (or an anode electrode) of each of the light emitting elements LE.

The third insulating layer INS3 may be disposed on the common electrode CME. For example, the third insulating layer INS3 may be a capping layer entirely disposed in the display area DA so as to cover the common electrode CME. The third insulating layer INS3 may include an inorganic insulating material such as silicon oxide (SiOₓ), silicon nitride (SiNₓ), silicon oxynitride (SiOₓN_{y}), aluminum oxide (AlₓO_{y}), or aluminum nitride (AlN), or other insulating materials.

In an embodiment, the display panel 100 may include the lens-type optical structures LS provided above the light emitting element layer 120. The display panel 100 may further include a protective layer PSV covering the lens-type optical structures LS.

The lens-type optical structures LS may be disposed in the respective emission areas EA so as to overlap the light emitting elements LE. In an embodiment, the lens-type optical structures LS may be convex lens-type optical structures provided above the light emitting elements LE, but a type and/or a shape of the optical structures are not limited thereto. By disposing the lens-type optical structures LS above the light emitting elements LE, it is possible to adjust and/or improve light emission characteristics of the pixels PX. The lens-type optical structures LS may have a dome shape.

The lens-type optical structures LS may each be made of a transparent material so that light incident from the light emitting elements LE may be transmitted therethrough. As an example, the lens-type optical structures LS may each be made of glass, plastic, ceramic, or other materials, and may be made of an optical material with a high refractive index.

The protective layer PSV may be disposed on the lens-type optical structures LS so as to cover the lens-type optical structures LS. The protective layer PSV may be made of a material (for example, plastic or organic glass, optical glass, ceramic, etc.) that is transparent and has durability, and a material of the protective layer PVS is not particularly limited as long as it is suitable for protecting the lens-type optical structures LS and the like within the scope of the invention. FIG. 3 has disclosed an embodiment in which the protective layer PSV has bends corresponding to shapes of the lens-type optical structures LS, but embodiments are not limited thereto. For example, the protective layer PSV may be formed in a shape in which it may planarize an upper surface of the display panel 100 on which the lens-type optical structures LS and the like are formed.

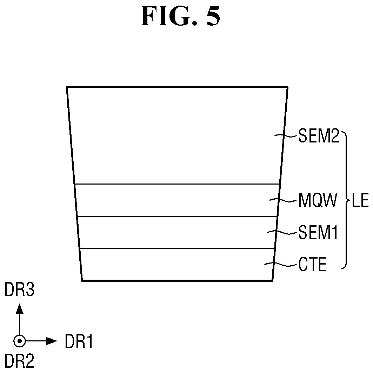

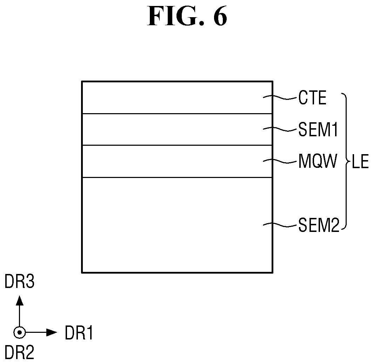

FIG. 4 is a schematic cross-sectional view illustrating a light emitting element LE according to an embodiment. FIG. 5 is a schematic cross-sectional view illustrating a light emitting element LE according to an embodiment. FIG. 6 is a schematic cross-sectional view illustrating a light emitting element LE according to an embodiment. For example, FIG. 5 illustrates an embodiment different from an embodiment of FIG. 4 in connection with a shape of a light emitting element LE, and FIG. 6 illustrates an embodiment different from an embodiment of FIG. 4 in connection with an arrangement direction of a light emitting element LE.

Referring to FIGS. 4 to 6, the light emitting element LE may include a first semiconductor layer SEM1, an active layer MQW, and a second semiconductor layer SEM2 that are sequentially disposed and/or stacked along the third direction DR3. In an embodiment, the light emitting element LE may further include a contact electrode CTE provided at one end or an end thereof. For example, the light emitting element LE may further include a contact electrode CTE provided at one end or an end thereof where the first semiconductor layer SEM1 is positioned. As shown in FIG. 5, the light emitting element LE may have a conical shape, wherein the semiconductor layer SEM2 may have a broader than the contact electrode CTE. At least one side surface of the light emitting element LE may be inclined, in particular both side surfaces may be inclined as shown in FIG. 5.

The light emitting element LE may further include additional layers according to embodiments. As an example, the light emitting element LE may further include an electron blocking layer disposed between the first semiconductor layer SEM1 and the active layer MQW, a superlattice layer disposed between the active layer MQW and the second semiconductor layer SEM2, and the like within the scope of the invention.

In an embodiment, the light emitting element LE may be an inorganic light emitting element made of an inorganic material. For example, the light emitting element LE may be an inorganic light emitting diode made of a nitride-based semiconductor material such as GaN, AlGaN, InGaN, AlInGaN, AlN, or InN, a phosphide-based semiconductor material such as GaP, GaInP, AlGaP, AlGaInP, AlP, or InP, or other inorganic materials.

The contact electrode CTE may be provided and/or formed at one end or an end of the light emitting element LE where the first semiconductor layer SEM1 is disposed. For example, the contact electrode CTE may be provided and/or formed on one surface or a surface of the first semiconductor layer SEM1. The contact electrode CTE may be an electrode for protecting the first semiconductor layer SEM1 and smoothly connecting the first semiconductor layer SEM1 to at least one circuit element, electrode, wiring line, conductive layer, and the like within the scope of the invention. The contact electrode CTE may include a metal, metal oxide, or other conductive materials.

The first semiconductor layer SEM1 may be disposed on the contact electrode CTE. In an embodiment, the first semiconductor layer SEM1 may include a nitride-based semiconductor material or a phosphide-based semiconductor material. For example, the first semiconductor layer SEM1 may include a nitride-based semiconductor material including at least one of GaN, AlGaN, InGaN, AlInGaN, AlN, and InN, or a phosphide-based semiconductor material including at least one of GaP, GaInP, AlGaP, AlGaInP, AlP, and InP. The first semiconductor layer SEM1 may also include other materials.

The first semiconductor layer SEM1 may include a semiconductor material doped with a first conductivity-type dopant. As an example, the first semiconductor layer SEM1 may be made of GaN (for example, p-GaN) or the like doped with a first conductivity-type dopant (for example, a p-type dopant) such as Mg, Zn, Ca, Se, or Ba.

The active layer MQW may be disposed on the first semiconductor layer SEM1. The active layer MQW may emit light by recombination of electron-hole pairs according to electrical signals applied through the first semiconductor layer SEM1 and the second semiconductor layer SEM2. For example, the active layer MQW may be a light emitting layer of the light emitting element LE.

The active layer MQW may include a material having a single or multiple quantum well structure. In case that the active layer MQW may include the material having the multiple quantum well structure, the active layer MQW may have a structure in which a plurality of well layers and barrier layers are alternately stacked each other. The active layer MQW may also include other Group III to Group V semiconductor materials depending on a wavelength band of emitted light.

In an embodiment, the active layer MQW may include a nitride-based semiconductor material or a phosphide-based semiconductor material. For example, the active layer MQW may include a nitride-based semiconductor material including at least one of GaN, AlGaN, InGaN, InGaAlN, AlN, InN, and AlInN, or a phosphide-based semiconductor material including at least one of GaP, GaInP, AlGaP, AlGaInP, AlP, and InP. As an example, the well layer may be made of InGaN, and the barrier layer may be made of GaN or AlGaN, but embodiments are not limited thereto. In case that the active layer MQW may include InGaN, a color of light emitted from the light emitting element LE may be controlled by adjusting a content of indium (In). The active layer MQW may also include other materials.

In an embodiment, the active layers MQW of the first light emitting element LE1, the second light emitting element LE2, and the third light emitting element LE3 illustrated in FIGS. 2 and 3 may emit light of the same color (for example, blue light). In an embodiment, the active layers MQW of the first light emitting element LE1, the second light emitting element LE2, and the third light emitting element LE3 may emit light of different colors (for example, red light, green light, and blue light).

The second semiconductor layer SEM2 may be disposed on the active layer MQW. In an embodiment, the second semiconductor layer SEM2 may include a nitride-based semiconductor material or a phosphide-based semiconductor material. For example, the second semiconductor layer SEM2 may include a nitride-based semiconductor material including at least one of GaN, AlGaN, InGaN, AlInGaN, AlN, and InN, or a phosphide-based semiconductor material including at least one of GaP, GaInP, AlGaP, AlGaInP, AlP, and InP. The second semiconductor layer SEM2 may also include other materials.

The second semiconductor layer SEM2 may include a semiconductor material doped with a second conductivity-type dopant. As an example, the second semiconductor layer SEM2 may be made of GaN (for example, n-GaN) doped with a second conductivity-type dopant (for example, an n-type dopant) such as Si, Ge, or Sn.

In an embodiment, the first semiconductor layer SEM1 and the second semiconductor layer SEM2 may have different thicknesses in a thickness direction of the light emitting element LE (for example, the third direction DR3). As an example, the second semiconductor layer SEM2 may have a greater thickness than the first semiconductor layer SEM1 in the thickness direction of the light emitting element LE. Accordingly, the active layer MQW may be positioned closer to a first end (for example, a p-type end) where the first semiconductor layer SEM1 and the like are provided than to a second end (for example, an n-type end) of the light emitting element LE where the second semiconductor layer SEM2 is provided.

In an embodiment, the light emitting element LE may be a vertical micro light emitting diode (LED) extending and/or stacked in the third direction DR3. For example, the light emitting element LE may be a micro LED of which each of a length in the first direction DR1, a length in the second direction DR2, and a length in the third direction DR3 is several to hundreds of micrometers (µm). In an embodiment, each of the length of the light emitting element LE in the first direction DR1, the length of the light emitting element LE in the second direction DR2, and the length of the light emitting element LE in the third direction DR3 may be about 100 µm or less.

In an embodiment, the light emitting element LE may include substantially vertical side surfaces as illustrated in FIG. 4. For example, the light emitting element LE may be patterned through vertical etching, and may have a rectangular or square cross-sectional shape of which a width of an upper surface and a width of a lower surface are substantially the same as each other.

A shape of the light emitting element LE may be variously changed according to embodiments. For example, the light emitting element LE may also have a cross-sectional shape of which a width of an upper surface and a width of a lower surface are different from each other.

In an embodiment, the light emitting element LE may have a reverse tapered cross-sectional shape as illustrated in FIG. 5. For example, the light emitting element LE may also have a reverse trapezoidal cross-sectional shape of which a width of an upper surface is greater than a width of a lower surface.

In an embodiment, the light emitting element LE may be disposed on the backplane substrate 110 so that the first semiconductor layer SEM1 is positioned below the active layer MQW and the second semiconductor layer SEM2 is positioned above the active layer MQW, as illustrated in FIG. 4. For example, the light emitting element LE may be disposed in each emission area EA so that the contact electrode CTE (or the first semiconductor layer SEM1) is in contact with the second bonding electrode BOE2 of FIG. 3 and the second semiconductor layer SEM2 (or another contact electrode provided on the semiconductor layer SEM2) is in contact with the common electrode CME. In this case, the common electrode CME may be a cathode electrode.

In an embodiment, the light emitting element LE may be disposed on the backplane substrate 110 so that the second semiconductor layer SEM2 is positioned below the active layer MQW and the first semiconductor layer SEM1 is positioned above the active layer MQW, as illustrated in FIG. 6. For example, the light emitting element LE may be disposed in each emission area EA so that the second semiconductor layer SEM2 (or another contact electrode provided on the semiconductor layer SEM2) is in contact with the second bonding electrode BOE2 of FIG. 3 and the contact electrode CTE (or the first semiconductor layer SEM1) is in contact with the common electrode CME. In this case, the common electrode CME may be an anode electrode.

In an embodiment, an arrangement direction of the light emitting element LE disposed on the second bonding electrode BOE2 may be adjusted by adjusting a direction in which each wafer die (or epitaxial die) for forming the light emitting element LE is transferred to a carrier substrate. As an example, a surface on which a bonding material is to be formed may be selected through a process of transferring the wafer die (or the epitaxial die) to the carrier substrate once or twice or more.

A structure, a material, a size, a shape, and the like, of the light emitting element LE are not limited to the above-described embodiments. For example, a structure, a material, a size, a shape, and the like, of the light emitting element LE may be variously changed according to embodiments.

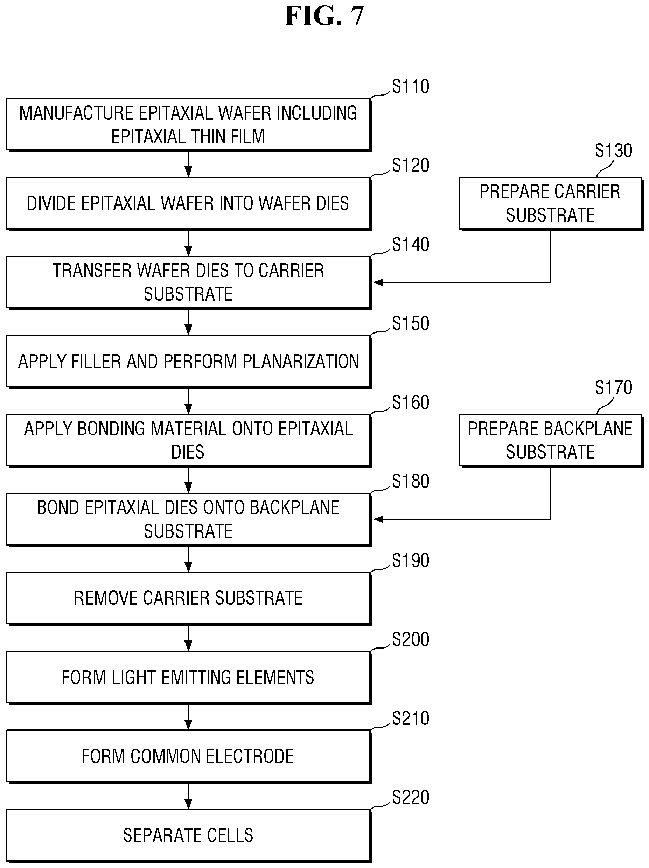

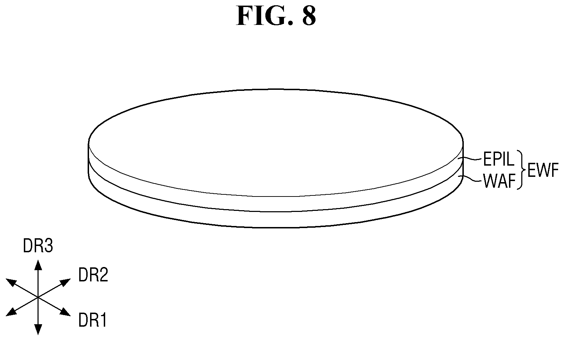

FIG. 7 is a flowchart illustrating a method for manufacturing the display device 10 according to an embodiment. For example, FIG. 7 is a flowchart illustrating a method for manufacturing the display panel 100 of the display device 10 according to an embodiment. FIGS. 8 to 22 are views for describing the method for manufacturing the display panel 100 according to an embodiment. For example, FIGS. 8 to 22 each illustrate given steps for forming the display panel 100 in the form of a schematic perspective view, a schematic cross-sectional view, or a schematic plan view.

Referring to FIGS. 7 to 9 and FIGS. 1 to 6, an epitaxial wafer EWF including an epitaxial thin film EPIL may be manufactured (S 110 in FIG. 7).

For example, as illustrated in FIG. 8, a wafer substrate WAF (or another type of substrate suitable for epitaxial growth) may be prepared, and the epitaxial thin film EPIL may be formed on the wafer substrate WAF. FIG. 8 is a schematic perspective view illustrating a schematic shape of the epitaxial wafer EWF.

The wafer substrate WAF may be a semiconductor substrate suitable for epitaxial growth of a semiconductor. For example, the wafer substrate WAF may be a substrate including a material such as silicon (Si), sapphire, SiC, GaN, GaAs, or ZnO. A type, a material, a shape, and the like, of the wafer substrate WAF are not particularly limited as long as epitaxial growth for manufacturing the light emitting element LE may be performed smoothly.

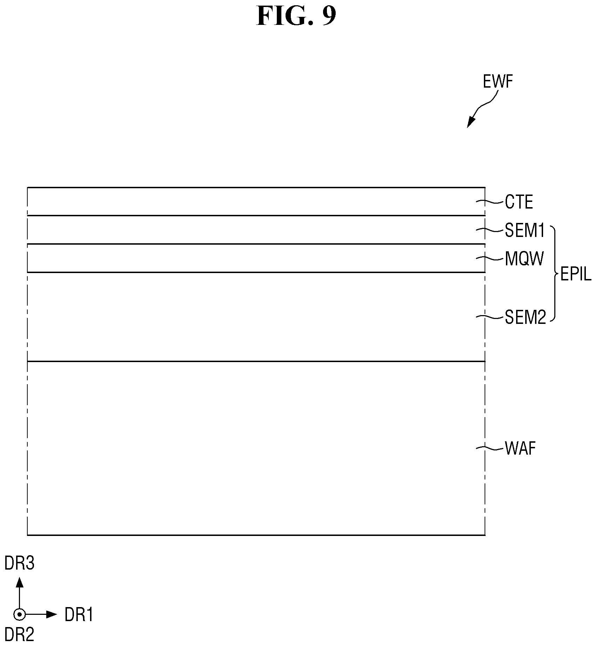

As illustrated in FIG. 9, the epitaxial thin film EPIL may include a second semiconductor layer SEM2, an active layer MQW, and a first semiconductor layer SEM1 that are sequentially disposed on the wafer substrate WAF. FIG. 9 is a schematic cross-sectional view illustrating a cross section of a portion of the epitaxial wafer EWF according to an embodiment.

For example, the second semiconductor layer SEM2, the active layer MQW, and the first semiconductor layer SEM1 may be sequentially formed on the wafer substrate WAF through epitaxial growth. In an embodiment, the second semiconductor layer SEM2, the active layer MQW, and the first semiconductor layer SEM1 may be formed by epitaxial growth using a process technology such as metal organic chemical vapor deposition (MOCVD), metal organic vapor phase epitaxy (MOVPE), molecular beam epitaxy (MBE), liquid phase epitaxy (LPE), or vapor phase epitaxy (VPE).

The second semiconductor layer SEM2 may be made of the material of the second semiconductor layer SEM2 previously described. For example, the second semiconductor layer SEM2 may be made of at least one nitride-based semiconductor material or phosphide-based semiconductor material, and may be formed as a single-layer or multilayer semiconductor layer. The second semiconductor layer SEM2 may be doped to include a second conductivity-type dopant (for example, an n-type dopant).

The active layer MQW may be made of the material of the active layer MQW previously described. For example, the active layer MQW may be made of at least one nitride-based semiconductor material or phosphide-based semiconductor material. In an embodiment, the active layer MQW having a multiple quantum well structure may be formed by alternately and/or repeatedly forming barrier layers and quantum well layers on the second semiconductor layer SEM2.

The first semiconductor layer SEM1 may be made of the material of the first semiconductor layer SEM1 previously described. For example, the first semiconductor layer SEM1 may be made of one nitride-based semiconductor material or phosphide-based semiconductor material, and may be formed as a single-layer or multilayer semiconductor layer. The first semiconductor layer SEM1 may be doped to include a first conductivity-type dopant (for example, a p-type dopant).

In an embodiment, in case that the light emitting element LE including the contact electrode CTE is manufactured as in embodiments of FIGS. 4 to 6, a process of forming the contact electrode CTE (or a conductive layer for forming a contact electrode CTE) on the epitaxial thin film EPIL may be additionally performed. For example, the epitaxial wafer EWF may further include the contact electrode CTE formed on the first semiconductor layer SEM1 as illustrated in FIG. 9.

The contact electrode CTE may be made of the material of the contact electrode CTE described above. The contact electrode CTE may be formed through a process such as a process of applying (for example, depositing) a conductive material onto the epitaxial thin film EPIL, and a method for forming the contact electrode CTE is not particularly limited.

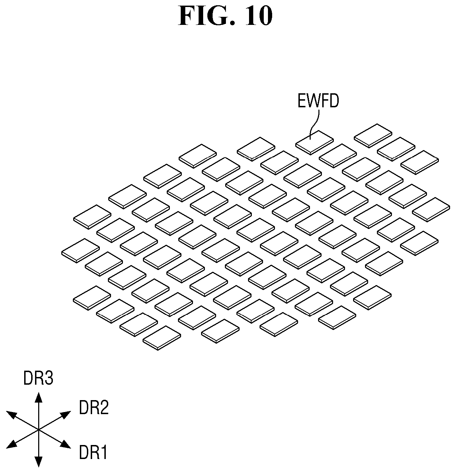

Referring to FIG. 10 and FIGS. 1 to 9, the epitaxial wafer EWF may be divided into wafer dies EWFD (also referred to as "epitaxial wafer dies") (S120 in FIG. 7). As an example, a plurality of wafer dies EWFD may be manufactured by dicing an epitaxial wafer EWF. FIG. 10 is a schematic perspective view illustrating a schematic shape of the wafer dies EWFD.

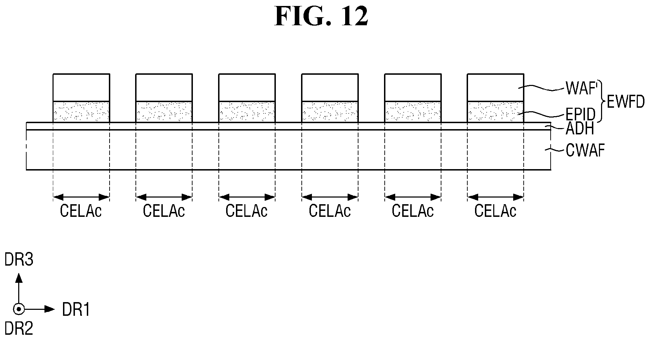

The wafer dies EWFD are smaller-sized pieces divided from the epitaxial wafer EWF, and structures of cross sections of the wafer dies EWFD may be substantially the same as a structure of a cross section of the epitaxial wafer EWF. For example, each of the wafer dies EWFD may include a wafer substrate (for example, a wafer substrate WAF' in FIG. 12) (or a piece of the wafer substrate WAF) divided in a smaller size and an epitaxial thin film EPIL divided in a smaller size. Hereinafter, a piece of the divided epitaxial thin film EPIL is referred to as an "epitaxial die". For example, the wafer dies EWFD may include the respective wafer substrates WAF' and the respective epitaxial dies divided from the epitaxial wafer EWF.

Each of the wafer dies EWFD may or may not include the contact electrode CTE according to embodiment. For convenience, illustration of the contact electrode CTE will be omitted in FIGS. 12 to 19.

In an embodiment, each of the wafer dies EWFD may have a size corresponding to an area of each cell area (for example, an area corresponding to the area of each cell area) of a backplane substrate (for example, a backplane mother substrate to be divided into a backplane substrate 110 of each display panel 100) including a plurality of cell areas for forming a plurality of display panels 100. For example, by dividing the epitaxial wafer EWF in the size corresponding to the area of each cell area of the backplane substrate including the plurality of cell areas, it is possible to manufacture the wafer dies EWFD having the size corresponding to the area of each cell area. In an embodiment, each of the wafer dies EWFD may have a size greater than or equal to an area of a display area DA positioned in each cell area.

In an embodiment, after the epitaxial wafer EWF is divided into the wafer dies EWFD, good products may be selected by performing an evaluation (for example, a quality test) for each of the wafer dies EWFD. Wafer dies EWFD selected as the good products may be used to form light emitting elements LE in each cell area through a subsequent process.

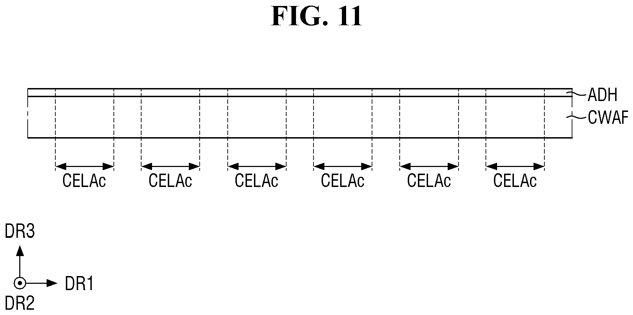

Referring to FIG. 11 and FIGS. 1 to 10, a carrier substrate CWAF may be prepared (S130 in FIG. 7).

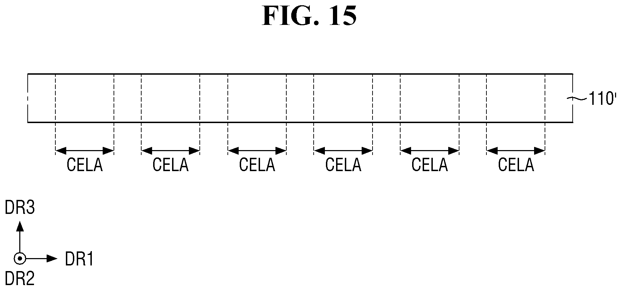

The carrier substrate CWAF may have a size and/or a shape corresponding to the backplane substrate (for example, which is a backplane substrate 110' of FIGS. 15 to 22 to be divided into the backplane substrate 110 of each display panel 100 and is also referred to as a "backplane mother substrate") including the plurality of cell areas. For example, the carrier substrate CWAF may be a wafer substrate having a size corresponding to an area of the backplane substrate (for example, an area corresponding to the area of the backplane substrate) and having a shape corresponding to a shape of the backplane substrate so that the wafer dies EWFD may be disposed on the cell areas of the backplane substrate used to simultaneously manufacture the plurality of display panels 100. In an embodiment, in case that a pixel process or the like for the display panels 100 is to be performed on the backplane substrate formed as a circular semiconductor substrate having a diameter of 12 inches and including the plurality of cell areas to be divided into the backplane substrate 110 of each display panel 100, a circular carrier substrate CWAF having a diameter of about 12 inches may be prepared. The carrier substrate CWAF may include cell areas CELAc corresponding to the cell areas of the backplane substrate.

In an embodiment, an adhesive layer ADH may be provided and/or formed on one surface or a surface of the carrier substrate CWAF. The adhesive layer ADH may be used to adhere the wafer dies EWFD and the carrier substrate CWAF to each other in a subsequent process.

In an embodiment, the adhesive layer ADH may be made of a material suitable for a process method to be applied in a separation process between the wafer dies EWFD (or the epitaxial dies EPID of the wafer dies EWFD) and the carrier substrate CWAF. For example, in case that the epitaxial dies EPID are to be separated from the carrier substrate CWAF by a laser lift off (LOO) method, the adhesive layer ADH may be made of a material capable of readily separating the epitaxial dies EPID from the carrier substrate CWAF by the LLO method. As an example, in case that the adhesive layer ADH is made of a material of which adhesive strength may be weakened by reacting sensitively to a laser beam, such as a thermoplastic adhesive, a thermally decomposable adhesive, or an incompletely cured adhesive, the epitaxial dies EPID and the carrier substrate CWAF may be readily separated from each other by the LLO method. A separation method between the epitaxial dies EPID and the carrier substrate CWAF is not limited to the LLO method, and the adhesive layer ADH may be made of a material suitable for a selected separation method.

In embodiments, the wafer dies EWFD (or the epitaxial dies EPID) may be first manufactured in a size corresponding to the cell area CELAc and transferred to the carrier substrate CWAF, the epitaxial dies EPID of the wafer dies EWFD may be bonded onto the backplane substrate, and the respective epitaxial dies EPID may be patterned into light emitting elements LE having a finer size through an etching process or the like within the scope of the invention. Accordingly, restrictions on a process method that may be utilized in each process for adhering and separating the epitaxial dies EPID and the carrier substrate CWAF to and from each other or a material (for example, an adhesive) used in each process may be reduced and a range of choices for the process method and the material may be widened. Accordingly, the adhesive layer ADH may be formed using various materials.

Referring to FIG. 12 and FIGS. 1 to 11, the wafer dies EWFD may be transferred to the carrier substrate CWAF (S140 in FIG. 7).

The wafer dies EWFD may be transferred to the carrier substrate CWAF at positions and/or intervals corresponding to the cell areas of the backplane substrate. For example, as illustrated in FIG. 12, the wafer dies EWFD may be aligned on one surface or a surface of the carrier substrate CWAF so as to be positioned in each cell area CELAc of the carrier substrate CWAF. In an embodiment, the wafer dies EWFD may be adhered to the carrier substrate CWAF by the adhesive layer ADH. In an embodiment, the wafer dies EWFD may be subjected to an evaluation step before being transferred to the carrier substrate CWAF, and only wafer dies EWFD selected as good products may be transferred to the carrier substrate CWAF.

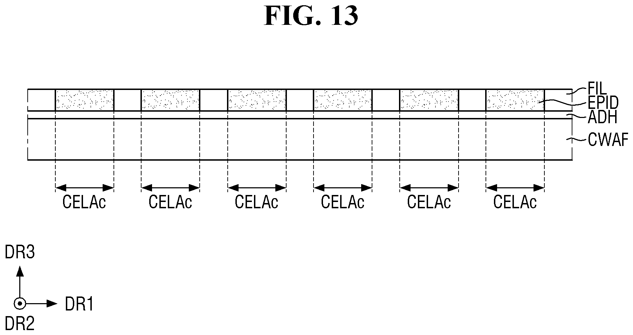

Referring to FIG. 13 and FIGS. 1 to 12, after the wafer dies EWFD are transferred to the carrier substrate CWAF, a process of applying a filler FIL and a planarization process may be performed (S150 in FIG. 7).

For example, gaps between the wafer dies EWFD may be filled by applying the filler FIL onto the carrier substrate CWAF on which the wafer dies EWFD are provided, and an upper surface of the carrier substrate CWAF on which the wafer dies EWFD and the filler FIL are provided may be planarized. In an embodiment, the planarization process may be performed by a polishing process such as a chemical mechanical polishing (CMP) process, but the method for planarizing the upper surface of the carrier substrate CWAF is not limited thereto. For example, the upper surface of the carrier substrate CWAF may also be planarized by an etching process or the like within the scope of the invention.

In a process of planarizing the upper surface of the carrier substrate CWAF, the respective wafer substrates WAF' may be removed from the wafer dies EWFD. Accordingly, the epitaxial dies EPID may be exposed. For example, upper surfaces of the epitaxial dies EPID may be exposed by performing the planarization process on the carrier substrate CWAF on which the wafer dies EWFD are provided. The filler FIL may remain on one surface or a surface of the carrier substrate CWAF in a form in which it is filled in the gaps between the epitaxial dies EPID.

In embodiments, by transferring the wafer dies EWFD having the size corresponding to the cell area CELAc to the carrier substrate CWAF and planarizing the upper surface of the carrier substrate CWAF, the planarization process may be facilitated and/or simplified and a defect that may occur in a manufacturing process of light emitting elements LE may be prevented or minimized, compared to a planarization process according to Comparative Example performed in a state in which the wafer dies EWFD (or the epitaxial dies EPID) are etched in a fine size corresponding to the light emitting elements LE.

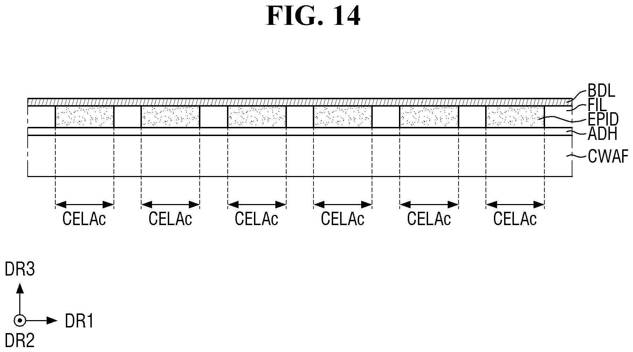

Referring to FIG. 14 and FIGS. 1 to 13, a bonding material may be applied onto the epitaxial dies EPID (S160 in FIG. 7).

For example, a conductive bonding layer BDL may be formed on the epitaxial dies EPID and the filler FIL by entirely applying a conductive bonding material onto the upper surface of the carrier substrate CWAF on which the epitaxial dies EPID are exposed. As an example, a conductive bonding layer BDL may be formed by entirely applying (for example, depositing) gold (Au), copper (Cu), aluminum (Al), tin (Sn), or other bonding metals onto the upper surface of the carrier substrate CWAF.

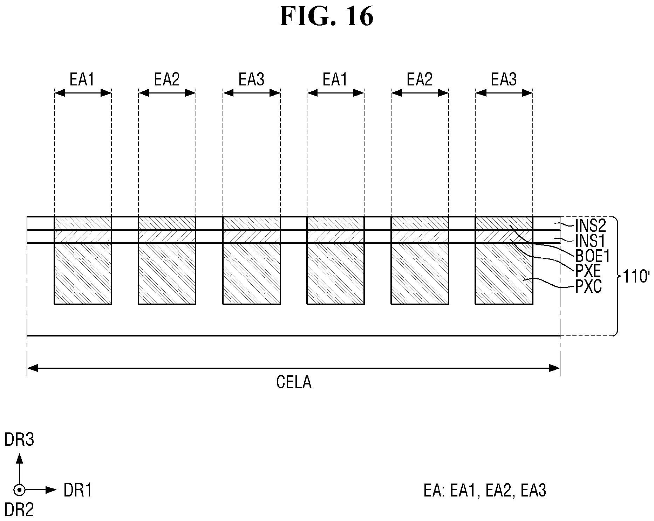

Referring to FIGS. 15 and 16 and further FIGS. 1 to 14, a backplane substrate 110' including a plurality of cell areas CELA may be prepared (S 170 in FIG. 7). FIG. 15 is a schematic cross-sectional view illustrating a schematic shape of the backplane substrate 110', and FIG. 16 is a schematic cross-sectional view illustrating each cell area CELA of the backplane substrate 110'.

Each of the cell areas CELA of the backplane substrate 110' may include emission areas EA in which light emitting elements LE are to be formed. The backplane substrate 110' may include pixel electrodes PXE and the like provided in the emission areas EA positioned in each of the cell areas CELA. For example, the backplane substrate 110' may include pixel electrodes PXE individually provided in the emission areas EA of each cell area CELA, pixel circuits PXC connected to the respective pixel electrodes PXE, first bonding electrodes BOE1 disposed on the respective pixel electrodes PXE, a first insulating layer INS1 disposed around the pixel electrodes PXE, and/or a second insulating layer INS2 disposed around the bonding electrodes BOE1. The cell areas CELA of the backplane substrate 110' may be divided into backplane substrates 110 of display panels 100 later.

The step of preparing the backplane substrate 110' may be performed independently of the step of manufacturing the wafer dies EWFD and/or the step of preparing the carrier substrate CWAF. For example, the step of preparing the backplane substrate 110' may be performed simultaneously with the step of manufacturing the wafer dies EWFD and/or the step of preparing the carrier substrate CWAF or may be performed before or after the step of manufacturing the wafer dies EWFD and/or the step of preparing the carrier substrate CWAF.

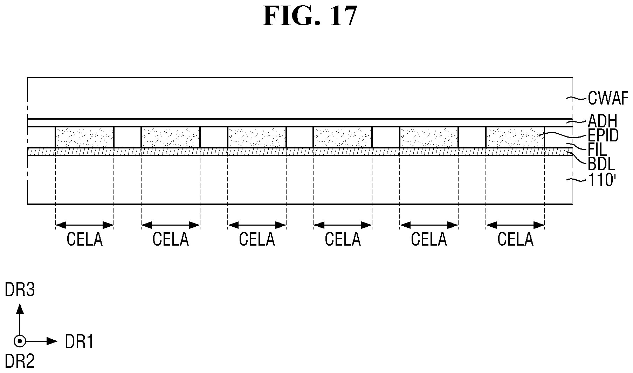

Referring to FIG. 17 and FIGS. 1 to 16, the epitaxial dies EPID may be bonded onto the backplane substrate 110' (S180 in FIG. 7).

For example, the carrier substrate CWAF may be disposed on the backplane substrate 110' in a state in which the epitaxial dies EPID are aligned to be positioned in each cell area CELA of the backplane substrate 110', and the carrier substrate CWAF and the backplane substrate 110' may be bonded to each other using the conductive bonding layer BDL. Accordingly, the epitaxial dies EPID may be bonded onto each cell area CELA of the backplane substrate 110'. The epitaxial dies EPID may be bonded onto the pixel electrodes PXE and the first bonding electrodes BOE1 positioned in the emission areas EA of each cell area CELA.

In an embodiment, alignment keys may be disposed on the backplane substrate 110' and the carrier substrate CWAF, respectively. Accordingly, the backplane substrate 110' and the carrier substrate CWAF may be readily and/or appropriately aligned with and bonded to each other. For example, the epitaxial dies EPID of the carrier substrate CWAF may be aligned with the display areas DA defined in the cell areas CELA of the backplane substrate 110' and be bonded onto the backplane substrate 110'.

In an embodiment, the epitaxial dies EPID may be bonded onto the first bonding electrodes BOE1 of the backplane substrate 110' by a bonding process between the backplane substrate 110' and the carrier substrate CWAF using a transient liquid phase (TLP) bonding method or a thermal compression (TC) bonding method. In case that the epitaxial dies EPID are bonded onto the backplane substrate 110' using the TLP bonding method or the TC bonding method, electrical resistance between the epitaxial dies EPID and the backplane substrate 110' (for example, the first bonding electrode BOE1 of the backplane substrate 110') may be reduced or minimized and performance and stability of the light emitting elements LE formed from the epitaxial dies EPID in a subsequent process may be secured. A bonding (or adhesion) method between the backplane substrate 110' and the carrier substrate CWAF is not limited thereto, and the backplane substrate 110' and the carrier substrate CWAF may also be bonded to each other by other methods.

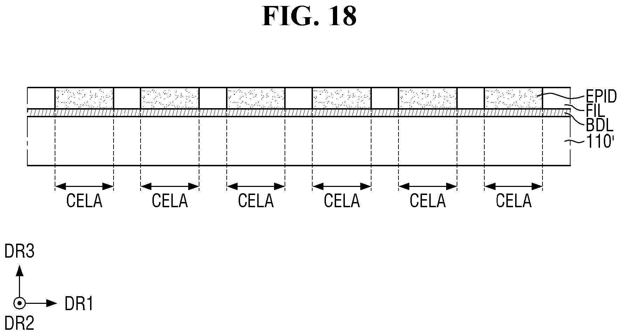

Referring to FIGS. 18 and 19 and FIGS. 1 to 17, the carrier substrate CWAF may be removed from the epitaxial dies EPID (S190 in FIG. 7).

For example, the carrier substrate CWAF and the adhesive layer ADH may be removed from the epitaxial dies EPID bonded onto the first bonding electrodes BOE1 (or the pixel electrodes PXE) of the backplane substrate 110'. In an embodiment, the carrier substrate CWAF may be readily and/or appropriately removed from the epitaxial dies EPID by a laser lift off (LLO) method. In case that the carrier substrate CWAF is separated using the LLO method, damage to the epitaxial dies EPID may be prevented or minimized, and reliability of the light emitting elements LE formed from the epitaxial dies EPID in a subsequent process may be secured.

However, a removal or separation method of the carrier substrate CWAF is not limited thereto, and the carrier substrate CWAF may also be removed by other methods. For example, the carrier substrate CWAF may also be removed through a polishing process such as a CMP process, an etching process, or the like within the scope of the invention.

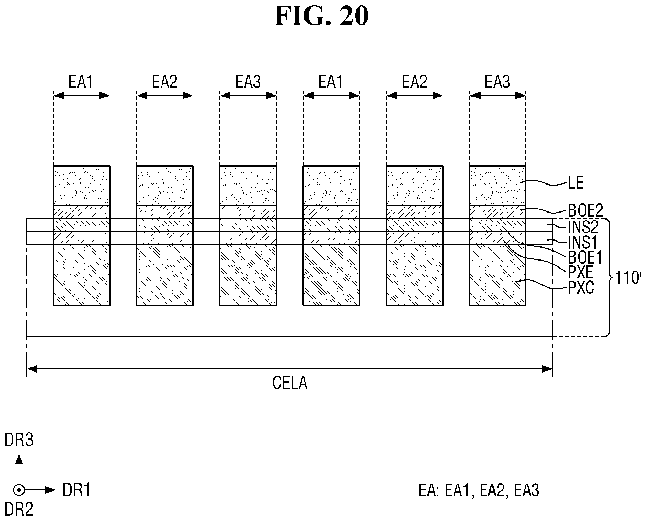

Referring to FIG. 20 and FIGS. 1 to 19, the light emitting elements LE may be formed (S200 in FIG. 7).

For example, the respective light emitting elements LE may be formed in the emission areas EA included in each cell area CELA by etching the epitaxial dies EPID. The light emitting elements LE may be formed on the pixel electrodes PXE and the first bonding electrodes BOE1 positioned in the respective emission areas EA.

Second bonding electrodes BOE2 may be formed between the first bonding electrodes BOE1 and the light emitting elements LE by etching the conductive bonding layer BDL. In an embodiment, the light emitting elements LE and the second bonding electrodes BOE2 may be formed in a size and/or s shape corresponding to the pixel electrodes PXE and/or the first bonding electrodes BOE1. For example, the light emitting elements LE and the second bonding electrodes BOE2 may be formed to each have an area corresponding to an area of the pixel electrodes PXE and the first bonding electrodes BOE1 and each have a shape following a shape of the pixel electrodes PXE and the first bonding electrodes BOE1 in plan view. However, embodiments are not limited thereto, and a size and a shape of the light emitting elements LE and the second bonding electrodes BOE2 may be variously changed according to embodiments.

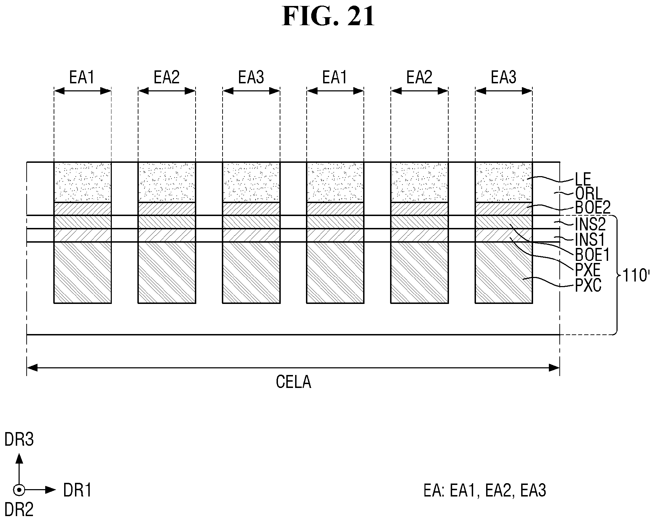

Referring to FIGS. 21 and 22 and FIGS. 1 to 20, a subsequent process for forming a light emitting element layer 120, including a process of forming a common electrode CME may be performed (S210 in FIG. 7).

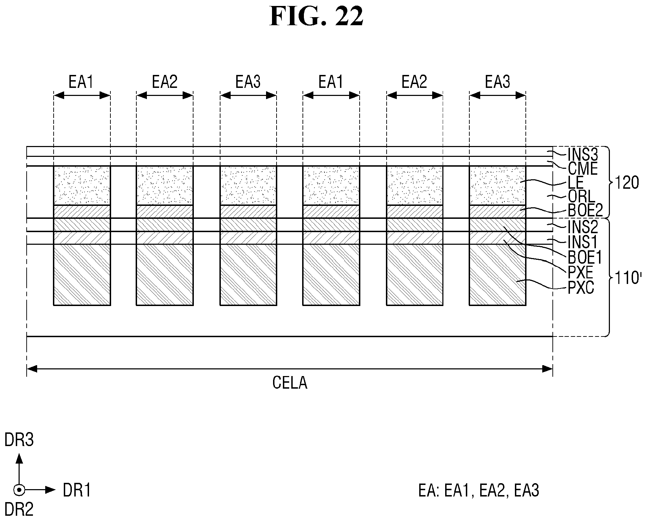

For example, as illustrated in FIG. 21, an organic film ORL may be formed between the light emitting elements LE in each cell area CELA. As an example, the organic film ORL may be filled between the light emitting elements LE at least in the display area DA. Thereafter, as illustrated in FIG. 22, a common electrode CME and a third insulating layer INS3 may be sequentially formed on the light emitting elements LE in each cell area CELA.

In an embodiment, in case that the display panel 100 including a light conversion layer and/or a color filter layer is to be manufactured, a process of forming the light conversion layer and/or the color filter layer above the light emitting element layer 120 or inside the light emitting element layer 120 may be additionally performed.

In an embodiment, in case that the display panel 100 including the lens-type optical structure LS as illustrated in FIG. 3 is to be manufactured, a process of attaching and/or forming the lens-type optical structure LS, the protective layer PSV, and the like, onto the light emitting element layer 120 may be additionally performed.

In case that a substantial manufacturing process of the display panels 100 is completed, a cell separation process may be performed (S220 in FIG. 7).

For example, the display panels 100 formed based on one backplane substrate 110' may be individually separated through cell separation. As an example, by cutting the backplane substrate 110' based on the cell areas CELA, respective cells positioned in the cell areas CELA may be separated into individual display panels 100.

Thereafter, the display device 10 including each display panel 100 may be manufactured by additionally performing a module process and the like within the s scope of the invention.

As described above, in embodiments, the epitaxial wafer EWF may be divided in cell units (for example, in a size corresponding to each cell area CELA or each cell) and transferred to the carrier substrate CWAF, and the epitaxial dies EPID may be bonded to each cell area CELA of the backplane substrate 110' and etched in each cell area CELA to be patterned into individual light emitting elements LE. Accordingly, the light emitting elements LE having a fine size may be efficiently formed in the emission areas EA included in each cell area CELA.

According to such embodiments, a restriction on a size of the wafer substrate WAF used for growth of the epitaxial thin film EPIL may be substantially eliminated, and use efficiency of the wafer substrate WAF may be increased. For example, the epitaxial wafer EWF may be divided in a size corresponding to the area of the display area DA included in each cell area CELA (for example, the epitaxial wafer EWF may be divided in the size greater than or equal to the area of the display area DA to the extent that a process error is included) and be used to manufacture the light emitting elements LE. Accordingly, the size of the wafer substrate WAF does not need to be adjusted to a size (for example, an area) of the backplane substrate 110', such that a range of choices for the wafer substrate WAF may be widened and a use area of the wafer substrate WAF may be increased or maximized to reduce a cost. As an example, the light emitting elements LE may be formed on the backplane substrate 110' having a size of 12 inches by manufacturing the wafer dies EWFD using the wafer substrate WAF having a size of 4 inches or 8 inches and transferring the wafer dies EWFD to the carrier substrate CWAF having a size of 12 inches. By way of example, the light emitting elements LE may be formed by manufacturing the wafer dies EWFD using the wafer substrate WAF having substantially the same size (for example, a size of 12 inches) as the backplane substrate 110' and using the epitaxial dies EPID of the wafer dies EWFD.

By aligning and bonding the respective epitaxial dies EPID onto the respective cell areas CELA of the backplane substrate 110' in cell units and patterning the epitaxial dies EPID into light emitting elements LE, it is possible to lower the difficulty of a panel process for manufacturing the display panel 100 and prevent or reduce an alignment error. For example, high-precision alignment according to the pixels PX and/or the emission areas EA having a fine size in a bonding process may become unnecessary, and the respective light emitting elements LE are formed in the emission areas EA through an etching process and the like, after the epitaxial dies EPID are bonded onto the backplane substrate 110', and thus, the light emitting elements LE may be readily and/or stably formed at appropriate positions. Accordingly, process efficiency of the display panel 100 and the display device 10 including the display panel 100 may be increased and yields of the display panel 100 and the display device 10 may be improved.

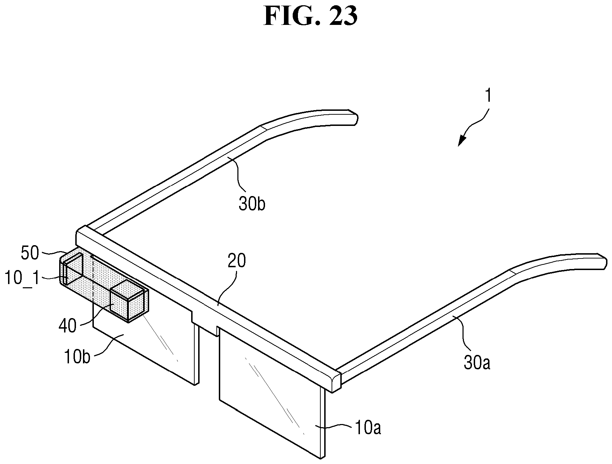

FIG. 23 is an illustrative view illustrating a virtual reality device 1 including a display device 10_1 according to an embodiment.

Referring to FIG. 23, the virtual reality device 1 according to an embodiment may be a glasses-type device. The virtual reality device 1 according to an embodiment may include the display device 10_1, a left eye lens 10a, a right eye lens 10b, a support frame 20, eyeglass frame legs 30a and 30b, a reflective member 40, and a display device housing part 50.

The virtual reality device 1 including the eyeglass frame legs 30a and 30b has been illustrated in FIG. 23, but the virtual reality device 1 according to an embodiment may also be applied to a head mounted display including a head mounted band that may be mounted on a user's head instead of the eyeglass frame legs 30a and 30b. For example, the virtual reality device 1 according to an embodiment is not limited to a form illustrated in FIG. 23, and may be applied in various forms to various other electronic devices.

The display device housing part 50 may include the display device 10_1 and the reflective member 40. An image displayed on the display device 10_1 may be reflected by the reflective member 40 and provided to a user's right eye through the right eye lens 10b. Accordingly, a user may view a virtual reality image displayed on the display device 10_1 through his/her right eye.

It has been illustrated in FIG. 23 that the display device housing part 50 is disposed at a right end of the support frame 20, but embodiments are not limited thereto. For example, the display device housing part 50 may be disposed at a left end of the support frame 20. In this case, an image displayed on the display device 10_1 may be reflected by the reflective member 40 and provided to a user's left eye through the left eye lens 10a. Accordingly, the user may view a virtual reality image displayed on the display device 10_1 through his/her left eye. By way of example, the display device housing parts 50 may be disposed at both the left and right ends of the support frame 20. In this case, the user may view a virtual reality image displayed on the display device 10_1 through both his/her left and right eyes.

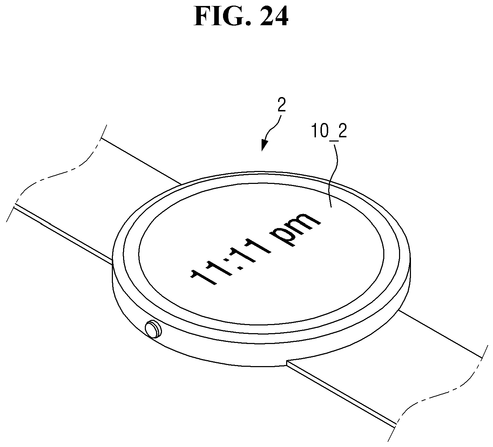

FIG. 24 is an illustrative view illustrating a smart device including a display device 10_2 according to an embodiment.

Referring to FIG. 24, the display device 10_2 according to an embodiment may be applied to a smart watch 2, which is one of the smart devices. A shape of a watch display unit of the smart watch 2 in plan view may follow a shape of the display device 10_2 in plan view. For example, in case that the display device 10_2 according to an embodiment has a circular or elliptical shape in plan view, the watch display unit of the smart watch 2 may have a circular or elliptical shape in plan view. By way of example, in case that the display device 10_2 according to an embodiment has a rectangular shape in plan view, the watch display unit of the smart watch 2 may have a rectangular shape in plan view. However, embodiments are not limited thereto, and the shape of the watch display unit of the smart watch 2 in plan view may not follow the shape of the display device 10_2 in plan view.

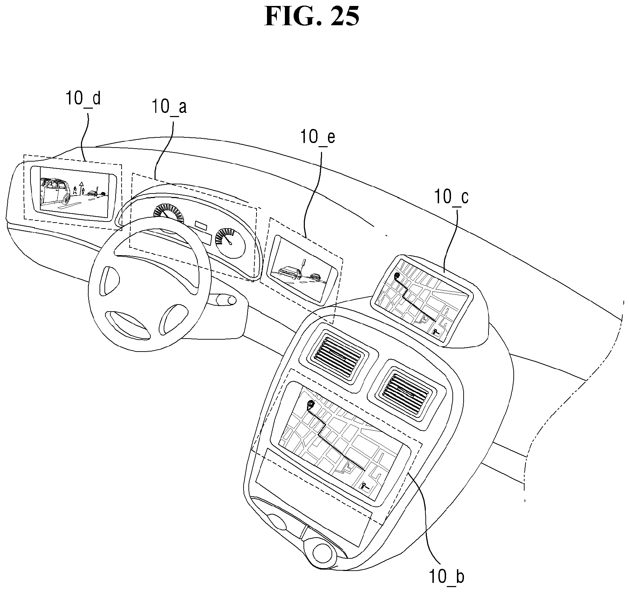

FIG. 25 is an illustrative view illustrating an instrument board and a center fascia of a vehicle including display devices 10_a, 10_b, 10_c, 10_d, and 10_e according to an embodiment. A vehicle to which the display devices 10_a, 10_b, 10_c, 10_d, and 10_e according to an embodiment are applied is illustrated in FIG. 25.

Referring to FIG. 25, the display devices 10_a, 10_b, and 10_c according to an embodiment may be applied to an instrument board of the vehicle, applied to a center fascia of the vehicle, or applied to a center information display (CID) disposed on a dashboard of the vehicle. By way of example, the display device 10_d and 10_e according to an embodiment may be applied to a room mirror display substituting for a side-view mirror of the vehicle.

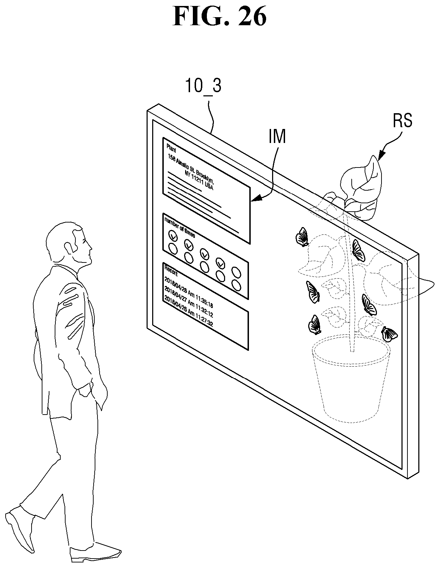

FIG. 26 is an illustrative view illustrating a transparent display device including a display device 10_3 according to an embodiment.

Referring to FIG. 26, the display device 10_3 according to an embodiment may be applied to a transparent display device. The transparent display device may transmit light therethrough while displaying an image IM. Accordingly, a user positioned on a front surface of the transparent display device may not only view the image IM displayed on the display device 10_3, but also see an object RS or a background positioned on a rear surface of the transparent display device. In case that the display device 10_3 is applied to the transparent display device, a display panel 100 may be formed on a substrate member including a light transmitting part capable of transmitting light therethrough or made of a material capable of transmitting light therethrough.

In concluding the detailed description, those skilled in the art will appreciate that many variations and modifications can be made to the embodiments without substantially departing from the principles of the invention. Therefore, the disclosed embodiments are used in a generic and descriptive sense only and not for purposes of limitation.

## Claims

1. A method for manufacturing a display device (10), comprising:
manufacturing an epitaxial wafer (EWF) including an epitaxial thin film (EPIL);
dividing the epitaxial wafer (EWF) into wafer dies (EWFD) having a size corresponding to an area of each cell area (CELA) of a backplane substrate (110) including cell areas (CELA);
transferring the wafer dies (EWFD) to a carrier substrate (CWAF);
forming a conductive bonding layer (BDL) on epitaxial dies (EPID) of the wafer dies (EWFD);
disposing the carrier substrate (CWAF) on the backplane substrate (110) such that the epitaxial dies (EPID) are disposed in each cell area (CELA) of the backplane substrate (110) and bonding the epitaxial dies (EPID) onto the backplane substrate (110);
removing the carrier substrate (CWAF) from the epitaxial dies (EPID); and
etching the epitaxial dies (EPID) to form respective light emitting elements (LE) in emission areas included in each cell area (CELA) of the backplane substrate (110).

2. The method for manufacturing a display device (10) of claim 1, wherein the carrier substrate (CWAF) has a size corresponding to an area of the backplane substrate (110), the carrier substrate (CWAF) includes cell areas (CELA) corresponding to the cell areas (CELA) of the backplane substrate (110).

3. The method for manufacturing a display device (10) of claim 1 or 2, wherein the transferring of the wafer dies (EWFD) to the carrier substrate (CWAF) includes aligning the wafer dies (EWFD) with the respective cell areas (CELA) of the carrier substrate (CWAF).

4. The method for manufacturing a display device (10) of at least one of claims 1 to 3, wherein the wafer dies (EWFD) include respective wafer substrates (WAF') and respective epitaxial dies (EPID) divided from the epitaxial wafer (EWF).

5. The method for manufacturing a display device (10) of at least one of claims 1 to 4, further comprising:
filling gaps between the wafer dies (EWFD) by applying a filler (FIL) onto the carrier substrate (CWAF) on which the wafer dies (EWFD) are disposed and planarizing an upper surface of the carrier substrate (CWAF) on which the wafer dies (EWFD) and the filler (FIL) are disposed after the transferring of the wafer dies (EWFD) onto the carrier substrate (CWAF) and before the forming of the conductive bonding layer (BDL).

6. The method for manufacturing a display device (10) of claim 5, wherein
in the planarizing of the upper surface of the carrier substrate (CWAF), the epitaxial dies (EPID) are exposed by removing the respective wafer substrates (WAF') from the wafer dies (EWFD), and
the conductive bonding layer (BDL) is formed by applying a conductive bonding material onto the upper surface of the carrier substrate (CWAF) on which the epitaxial dies (EPID) are exposed.

7. The method for manufacturing a display device (10) of at least one of claims 1 to 6, further comprising:
selecting products by evaluating the wafer dies (EWFD) before the transferring of the wafer dies (EWFD) to the carrier substrate (CWAF),
wherein the wafer dies (EWFD) selected as the products are transferred to the carrier substrate (CWAF).

8. The method for manufacturing a display device (10) of at least one of claims 1 to 7, wherein the backplane substrate (110) includes pixel electrodes (PXE) individually disposed in the emission areas of each cell area (CELA) of the backplane substrate (110).

9. The method for manufacturing a display device (10) of claim 8, wherein in the etching of the epitaxial dies (EPID), the respective light emitting elements (LE) are formed on the pixel electrodes (PXE).

10. The method for manufacturing a display device (10) of claim 8 or 9, wherein the backplane substrate (110) further includes first bonding electrodes (BOE1) disposed on the pixel electrodes (PXE).

11. The method for manufacturing a display device (10) of claim 10, wherein in the bonding of the epitaxial dies (EPID) onto the backplane substrate (110), the epitaxial dies (EPID) are bonded onto the first bonding electrodes (BOE1) by a transient liquid phase (TLP) bonding method or a thermal compression (TC) bonding method.

12. The method for manufacturing a display device (10) of claim 10 or 11, further comprising:
forming second bonding electrodes (BOE2) between the first bonding electrodes (BOE1) and the light emitting elements (LE) by etching the conductive bonding layer (BDL).

13. The method for manufacturing a display device (10) of at least one of claims 1 to 12, wherein in the removing of the carrier substrate (CWAF), the carrier substrate (CWAF) is removed from the epitaxial dies (EPID) by a laser lift off (LLO) method.

14. The method for manufacturing a display device (10) of at least one of claims 1 to 13, further comprising:
forming a common electrode on the light emitting elements (LE) in each cell area (CELA) of the backplane substrate (110).

15. The method for manufacturing a display device (10) of at least one of claims 1 to 14, further comprising:
forming lens-type optical structures (LS) on a light emitting element layer (120) including the light emitting elements (LE) and the common electrode.

16. The method for manufacturing a display device (10) of at least one of claims 1 to 15, further comprising:
separating respective cells corresponding to the cell areas (CELA) into individual display panels (100) by cutting the backplane substrate (110) based on the cell areas (CELA) of the backplane substrate (110).

17. A method for manufacturing a display device (10), comprising:
preparing a backplane substrate (110) including cell areas (CELA) and pixel electrodes (PXE) individually disposed in emission areas disposed in each of the cell areas (CELA);
manufacturing wafer dies (EWFD) having a size corresponding to each of the cell areas (CELA) and including respective epitaxial dies (EPID);
preparing a carrier substrate (CWAF) having a size corresponding to the backplane substrate (110) and including cell areas (CELA) corresponding to the cell areas (CELA) of the backplane substrate (110);
transferring the wafer dies (EWFD) to the carrier substrate (CWAF);
planarizing an upper surface of the carrier substrate (CWAF) such that the epitaxial dies (EPID) of the wafer dies (EWFD) are exposed and forming a conductive bonding layer (BDL) on the epitaxial dies (EPID);
bonding the epitaxial dies (EPID) onto the pixel electrodes (PXE) using the conductive bonding layer (BDL); and
forming respective light emitting elements (LE) on the pixel electrodes (PXE) by etching the epitaxial dies (EPID).

18. The method for manufacturing a display device (10) of claim 17, wherein the transferring of the wafer dies (EWFD) to the carrier substrate (CWAF) includes aligning the wafer dies (EWFD) with the respective cell areas (CELA) of the carrier substrate (CWAF).

19. The method for manufacturing a display device (10) of claim 17 or 18, wherein the backplane substrate (110) further includes first bonding electrodes (BOE1) disposed on the pixel electrodes (PXE), and
the epitaxial dies (EPID) are bonded onto the first bonding electrodes (BOE1) by a transient liquid phase bonding method or a thermal compression bonding method.

20. The method for manufacturing a display device (10) of claim 19, further comprising:
forming second bonding electrodes (BOE2) between the first bonding electrodes (BOE1) and the light emitting elements (LE) by etching the conductive bonding layer (BDL).
